(19) Europäisches Patentamt
European Patent Office
Office européen des brevets

(11) **EP 4 078 202 B1**

(12) **EUROPÄISCHE PATENTSCHRIFT**

(45) Veröffentlichungstag und Bekanntmachung des Hinweises auf die Patenterteilung:
**09.04.2025  Patentblatt 2025/15**

(21) Anmeldenummer: **20829305.0**

(22) Anmeldetag: **18.12.2020**

(51) Internationale Patentklassifikation (IPC):
**G01R 29/12** (2006.01)    **G02B 26/08** (2006.01)

(52) Gemeinsame Patentklassifikation (CPC):
**G01R 29/12; G02B 26/0841**

(86) Internationale Anmeldenummer:
**PCT/AT2020/060478**

(87) Internationale Veröffentlichungsnummer:
**WO 2021/119710 (24.06.2021 Gazette 2021/25)**

(54) **VERFAHREN UND VORRICHTUNG ZUM ERFASSEN EINES ELEKTRISCHEN FELDES**

METHOD AND DEVICE FOR SENSING ELECTRIC FIELD

PROCÉDÉ ET DISPOSITIF DE DÉTECTION DE CHAMP ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2019  AT 511042019**

(43) Veröffentlichungstag der Anmeldung:
**26.10.2022  Patentblatt 2022/43**

(73) Patentinhaber:
• **TECHNISCHE UNIVERSITÄT WIEN**
  **1040 Wien (AT)**
• **Universität für Weiterbildung Krems (Donau-Universität Krems)**
  **3500 Krems/Donau (AT)**

(72) Erfinder:
• **KEPLINGER, Franz**
  **1040 Wien (AT)**
• **KAINZ, Andreas**
  **1040 Wien (AT)**
• **HORTSCHITZ, Wilfried**
  **3500 Krems/Donau (AT)**
• **STEINER, Harald**
  **3500 Krems/Donau (AT)**

(74) Vertreter: **SONN Patentanwälte GmbH & Co KG**
**Riemergasse 14**
**1010 Wien (AT)**

(56) Entgegenhaltungen:
EP-A1- 1 569 023       WO-A1-2019/120795
CN-A- 103 675 481      CN-A- 108 508 284
US-A1- 2019 137 555

**Beschreibung**

Die Erfindung betrifft einen Sensor zum Messen einer elektrischen Feldstärke eines elektrischen Feldes, welcher ein Basiselement und ein Sensorelement mit zumindest einem elektrischen Leiter aufweist, wobei das Sensorelement durch die Wirkung des elektrischen Feldes auf den elektrischen Leiter von einer Ruheposition in eine Messposition auslenkbar ist, wobei eine Auswerteeinheit zur Erfassung der Auslenkung des Sensorelements in der Messposition vorgesehen ist, wobei ein Gegenelement mit zumindest einem elektrisch leitfähigen Kopplungsbereich vorgesehen ist, wobei sich der elektrisch leitfähige Kopplungsbereich am Gegenelement im Ruhezustand des Sensorelements benachbart des Kopplungsabschnitts des elektrischen Leiters am Sensorelement erstreckt.

Die elektrische Feldstärke ist eine der fundamentalen physikalischen Größen, deren quantitative Messung, vor allem bei niedrigen Frequenzen oder statischen Feldern, schwierig ist. Ein Grund dafür ist die leichte Störbarkeit des Feldes durch die Messung selbst. Insbesondere führen geerdete Zuleitungen und metallische Komponenten zu einer starken Verzerrung des elektrischen Feldes. Statische und niederfrequente Felder können nur in wohldefinierten Umgebungen gemessen werden, was eine Messung eines solchen Feldes vor Ort, wie zum Beispiel in Hochspannungsanlagen, sehr schwierig gestaltet.

Eine störungsfreie Messung der elektrischen Feldstärke kann aber durchaus wichtig sein. Beispielsweise ist die Kenntnis der Feldstärke für Warneinrichtungen unabdingbar, welche vor Hochspannungen in Energieversorgungseinrichtungen, vor einem drohenden Blitzschlag oder vor elektrostatischen Ladungen warnen. Derartige Warneinrichtungen können stationär bei Anlagen mit Gefährdungspotenzial, beispielsweise bei Krananlagen, bei Hochspannungsleitungen, zur Blitzwarnung bei Flughäfen, oder bei Getreide- oder Holzverarbeitungsanlagen, verbaut werden. Im Bereich des Arbeitnehmerschutzes ist eine mobile Anwendung solcher Warnsysteme gefragt. Diese können beispielsweise an der Arbeitskleidung oder an einem Helm angebracht werden und können auch zukünftig der Überwachung der Einhaltung von Expositionsgrenzwerten für elektrische Felder dienen. Eine mobile Verwendung erfordert eine kompakte Ausführungsform, sollte frei von der Notwendigkeit einer Kalibrierung sein und sollte auch nicht durch schwer beeinflussbare Umweltparameter, wie beispielsweise Temperatur, beeinflusst werden.

Für die Messung elektrischer Felder wurden bisher unter anderem Feldmühlen verwendet. Diese basiert auf der Änderung eines Elektrodenpotenzials, welches durch das elektrische Feld influenziert wird. Um eine messbare Änderung zu erzeugen, muss die Elektrode regelmäßig mit einer weiteren Elektrode, die auf Masse liegt, abgeschirmt werden. Diese Abschirmung erzeugt eine massive Feldverzerrung, welche aufwändige ortsabhängige Kalibrier- und Kompensationsvorgänge nötig macht.

Eine weitere Möglichkeit besteht in der Verwendung elektrooptischer Sensoren. Deren Kernelement ist ein Kristall, der seine optischen Eigenschaften in Abhängigkeit der auf ihn wirkenden elektrischen Feldstärke ändert. Diese Sensoren erzeugen keine Verzerrung des elektrischen Feldes, weisen aber eine starke Querempfindlichkeit gegenüber Temperaturschwankungen auf.

Weiters existieren auch potenzialfreie elektrische Messsysteme, die ohne geerdete Komponenten auskommen, aber relativ große Messelektroden aufweisen. Gemessen wird die Spannung die zwischen den Elektroden im Feld entsteht. Durch ihre Größe ist eine mobile Verwendung stark eingeschränkt und eine (quasi) punktförmige Messung nicht möglich.

Eine weitere Möglichkeit der Messung besteht in der Verwendung mikromechanischer Strukturen, die aus zwei elektrisch leitfähigen Elementen bestehen. Im elektrischen Feld wird in diese eine Ladung influenziert und es entsteht eine Anziehung zwischen den beiden Elementen. Einer der beiden Teile ist dabei beweglich gelagert und kann sich verschieben. Diese Verschiebung wird ausgelesen und daraus die elektrische Feldstärke ermittelt. Das System hat jedoch den Nachteil, dass es bei geringen Feldstärken überproportional unempfindlich ist und die Richtungsinformation des Feldes verloren geht. Darüber hinaus erzeugen Wechselfelder einen konstanten Anteil, der das Vorhandensein eines Gleichfeldes vortäuscht.

Aus dem Artikel Liyanage, S.; Shafai, C.; Chen, T.; Rajapakse, A. "Torsional Moving Electric Field Sensor with Modulated Sensitivity and without Reference Ground", Proceedings 2017, 1, 350 ist ein Sensor bekannt, der die oben genannten Probleme reduziert. Dieser Sensor besteht aus einem plättchenförmigen Sensorelement rechteckiger Grundfläche. Auf das Sensorelement sind großflächig zwei leitfähige, voneinander elektrisch isolierte Elektroden aufgebracht. Weiters ist der Sensor an zwei gegenüberliegenden Seiten verschwenkbar gelagert. Die beiden Elektroden befinden sich jeweils auf unterschiedlichen Seiten der Schwenkachse. Die Elektroden verfügen über jeweils einen Anschluss. Beide Anschlüsse sind über jeweils eine Lagerstelle nach außen geführt. An den beiden Elektroden wird für die Messung eine Spannung angelegt, die Ladungen in die Elektroden einprägt. Wenn sich das Sensorelement mit den eingeprägten Ladungen in einem elektrischen Feld befindet, wirkt durch das Feld eine Kraft auf die Ladungen. Durch das jeweils unterschiedliche Vorzeichen der Ladung in den Elektroden wirkt die Kraft für jede Elektrode in eine entgegengesetzte Richtung parallel zum Feld. Diese Kräfte bewirken nun eine Drehung des Sensorplättchens, welche proportional zur elektrischen Feldstärke ist. Diese Drehung wird in weiterer Folge optisch ausgelesen und daraus auf die Feldstärke rückgeschlossen. Selbst dieser Sensor weist jedoch eine eher geringe Messgenauigkeit auf. Weiters kann es zu Verzerrungen des zu messenden Feldes kommen.

Beispielsweise zeigt die WO 2019 120 795 A1 eine Vorrichtung zur Messung eines elektrischen Felds (E) mit einer mikromechanischen Struktur aus elektrisch leitendem Material. Die mikromechanische Struktur weist einen Rahmenabschnitt und eine beweglichen Abschnitt auf. Ein elektrisches Feld $E_x$ in Richtung x bewirkt eine elektrische Polarisation der mikromechanischen Struktur und eine Kraft $F_x$. Diese Kraft $F_x$ führt zu einer Änderung der räumlichen Anordnung des beweglichen Abschnitts relativ zum Rahmenabschnitt in Richtung x. Es sind Detektionsmittel vorgesehen, um diese Änderung zu bestimmen.

Weitere Sensoren zur Messung eines elektrischen Feldes sind beispielsweise aus der US 2019 137 555 A1, der CN 103 675 481 B und der CN 108 508 284 A bekannt.

Die EP 1 569 023 A1 zeigt ein Mikro-Spiegelelement zum Ablenken von einfallendem Licht. Das Mikro-Spiegelelement umfasst eine bewegliche (Spiegel-) Einheit, einen Rahmen und ein Verbindungsstück, um diese zu verbinden. Das Verbindungsstück umfasst eine Vielzahl von elektrisch getrennten Torsionsstäben, mittels derer verschiedene elektrische Potentiale angelegt werden können, um die bewegliche Einheit gegenüber dem Rahmen zu drehen.

Die Aufgabe der vorliegenden Erfindung besteht darin, einen Sensor zur Messung der Feldstärke eines elektrischen Feldes vorzuschlagen, welcher die Nachteile des Standes der Technik vermeidet oder zumindest reduziert. Die Erfindung setzt sich insbesondere zum Ziel, eine höhere Messgenauigkeit zu erreichen und eine Verzerrung des zu messenden Feldes zu minimieren.

Dies Aufgabe wird durch einen Sensor mit den Merkmalen aus Anspruch 1 und ein Verfahren mit den Merkmalen von Anspruch 15 gelöst. Bevorzugte Ausführungsformen sind in den abhängigen Ansprüchen angegeben.

Der erfindungsgemäße Sensor umfasst daher zumindest ein Gegenelement mit zumindest einem elektrisch leitfähigen Kopplungsbereich, welcher zur kapazitiven Kopplung mit einem Kopplungsabschnitt des elektrischen Leiters am Sensorelement mit einer Spannungsquelle verbunden ist, wobei die Spannungsquelle eine Wechselstrom-Spannungsquelle ist, wobei sich der elektrisch leitfähige Kopplungsbereich am Gegenelement im Ruhezustand des Sensorelements benachbart des Kopplungsabschnitts des elektrischen Leiters am Sensorelement erstreckt.

Zum Messen der elektrischen Feldstärke kann die Auslenkung des Sensorelements erfasst werden. Diese Auslenkung resultiert aus der Kraft auf die Ladungsträger des elektrischen Leiters im äußeren elektrischen Feld. Die resultierende Kraft kann nach der Formel

$$F = Q \times E$$

berechnet werden, wobei F die Kraft, Q die Ladung und E die elektrische Feldstärke ist, welche auf die Ladung Q wirkt. Somit ist die Kraft proportional zur Ladung und zur Feldstärke. Je nach Ausführungsform des Sensors ruft diese Kraft eine entsprechende Auslenkung des Sensorelements hervor, beispielsweise eine Verdrehung des Sensorelements um seine Längsachse, eine Aufwärts- oder Abwärtsverbiegung, eine Durchbiegung oder eine transversale Verschiebung des Sensorelements. Das Sensorelement ist vorzugsweise elastisch am Basiselement gelagert, so dass eine Rückstellkraft auf das Sensorelement wirkt, welche im Wesentlichen proportional zur Auslenkung des Sensorelements aus der Ruheposition ist. Die Ruheposition bezieht sich dabei auf die Stellung des Sensorelements in Abwesenheit des äußeren elektrischen Feldes, d.h. im unbelasteten Zustand. Für die Messung der Feldstärke ist insbesondere das Drehmoment entscheidend, welches auf das Sensorelement oder seine Verbindungen mit dem Basiselement wirkt.

Erfindungsgemäß ist eine kapazitive Kopplung zwischen dem Kopplungsabschnitt am Sensorelement und dem Kopplungsbereich am Gegenelement vorgesehen. Zu diesem Zweck verläuft der Kopplungsbereich am Gegenelement benachbart, d.h. in unmittelbarer Nähe des Kopplungsabschnitts am Sensorelement. Der Vorteil der kapazitiven Kopplung des Kopplungsabschnitts des Sensorelements mit dem benachbarten Kopplungsbereich des Gegenelements liegt darin, dass aufgrund der dadurch entstehenden Kapazität C die eingeprägte Ladung im Kopplungsabschnitt am Sensorelement gemäß der Formel

$$Q = C \times U,$$

erhöht wird, wobei Q die Ladung, C die Kapazität und U die angelegte Spannung ist. Somit wird eine stärkere Kraft auf das Sensorelement ausgeübt, wodurch das Ausmaß der Auslenkung des Sensorelements erhöht wird. Vorteilhafterweise kann so die Messgenauigkeit bei der Messung des elektrischen Feldes verbessert werden.

Die Spannungsquelle, welche eine Wechselstrom-Spannungsquelle ist, ermöglicht es dabei, die eingeprägte Ladungsmenge an die zu messende Feldstärke anzupassen, was eine Vergrößerung des Messbereiches zulässt. Die Verwendung einer Wechselstrom-Spannungsquelle ermöglicht eine resonante Messung des elektrischen Feldes, wodurch die Messung eines statischen elektrischen Feldes mit besonders hoher Genauigkeit ermöglicht wird.

Das Sensorelement ist beweglich an dem Basiselement gelagert. Als Basiselement ist bevorzugt ein Plättchen vorgesehen. Das Gegenelement kann unbeweglich oder beweglich bezüglich des Basiselements angeordnet sein.

In einer bevorzugten Ausführungsform erstreckt sich der Kopplungsbereich am Gegenelement parallel zum Kopplungsabschnitt des elektrischen Leiters am Sensorelement. Dadurch wird die kapazitive Kopplung verstärkt. Bevorzugt beträgt der Normalabstand zwischen dem Kopplungsbereich am Gegenelement und dem Kopplungsabschnitt am Sensorelement (bezogen auf die einander zugewandten Längsränder von Kopplungsbereich bzw. -abschnitt) weniger als 10 $\mu$m, besonders bevorzugt weniger als 1 $\mu$m.

Um den elektrischen Leiter am Sensorelement zumindest entlang des Kopplungsabschnitts in die Nähe des Kopplungsbereichs am Gegenelement führen zu können, ist es besonders bevorzugt, wenn der Kopplungsabschnitt am Sensorelement und der Kopplungsbereich am Gegenelement an einander zugewandten Rändern des Sensor- bzw. Gegenelements verlaufen. Somit ist zwischen den einander zugewandten Rändern des Sensor- bzw. Gegenelements ein Spalt ausgebildet, welcher bevorzugt eine Spaltbreite von weniger als 10 $\mu$m, insbesondere weniger als 1 $\mu$m (Mikrometer) aufweist. Dadurch kann die Kapazität besonders stark erhöht werden. Somit ist der kleinstmögliche Abstand zwischen dem Kopplungsbereich am Gegenelement und dem Kopplungsabschnitt am Sensorelement durch die Spaltbreite festgelegt. Durch die Nähe von Kopplungsbereich und Kopplungsabschnitt ist es möglich, die leitfähigen Flächen zu verringern, ohne eine starke Minderung der Kapazität in Kauf nehmen zu müssen. Vorzugsweise wird der Teil der leitfähigen Fläche reduziert, der den größten Abstand zum Spalt aufweist und den kleinsten Einfluss auf die Kapazität hat. Eine Verringerung der Ausmaße der leitfähigen Materialien im Messvolumen führt zu einer geringeren Feldverzerrung und dadurch zu einer erhöhten Genauigkeit der Messung.

Gemäß einem besonderen Merkmal bilden der Kopplungsbereich am Gegenelement und der Kopplungsabschnitt am Sensorelement eine Interdigitalstruktur aus. Diese Interdigitalstruktur zeichnet sich dadurch aus, dass der Kopplungsbereich am Gegenelement und der Kopplungsabschnitt am Sensorelement ineinandergreifende Finger aufweist. Dadurch vergrößert sich die effektive Länge der Kopplungsstrecke, entlang welcher der Kopplungsbereich am Gegenelement benachbart des Kopplungsabschnitts am Sensorelement verläuft. Vorteilhafterweise kann so die Kapazität aufgrund der kapazitiven Kopplung weiter erhöht werden, ohne dabei die mechanischen Eigenschaften des Sensorelements, wie beispielsweise die Resonanzfrequenz, wesentlich zu verändern.

In einer Ausführungsform des Sensors ist das Gegenelement in der Ruheposition des Sensorelements in derselben Ebene wie das Sensorelement angeordnet. Der Vorteil dieser Anordnung ist, dass die Herstellung des Sensors, beispielsweise als " Micro-Electro-Mechanical System" (kurz MEMS), sehr einfach ist, da sie in wenigen Schritten aus einem Grundelement hergestellt werden kann. Ein weiterer Vorteil ist, dass der Abstand zwischen dem Kopplungsbereich am Gegenelement und dem Kopplungsabschnitt am Sensorelement kleiner als die größtmögliche Auslenkung des Sensorelements in der Messposition sein kann.

In einer weiteren Ausführungsform ist das Gegenelement in der Ruheposition des Sensorelements parallel und in einem Normalabstand zu dem Sensorelement angeordnet. Dies ermöglicht eine Anordnung, in der sich das Sensorelement im Wesentlichen über dem Gegenelement befindet. Durch die bessere Überdeckung von Kopplungsbereich am Gegenelement und Kopplungsabschnitt am Sensorelement kann eine hohe Kapazität erzielt werden.

In einer weiteren Ausführungsform ist das Sensorelement an zwei gegenüberliegenden Enden mit dem Basiselement verbunden. Vorzugsweise sind die Verbindungen zwischen dem Sensorelement und dem Basiselement federnd ausgebildet, so dass die Auslenkung des Sensorelements zu einer entsprechenden Rückstellkraft führt. Eine Verbindung des Sensorelements an zwei gegenüberliegenden Enden hat den Vorteil, dass der Sensor weniger empfindlich gegenüber mechanischen Einwirkungen, wie beispielsweise eine Bewegung, insbesondere Beschleunigung, ist. Somit ist eine genauere Messung bei mobilem Einsatz des Sensors möglich.

In einer weiteren Ausführungsform ist das eine Ende des Sensorelements mit dem Basiselement verbunden, wobei das andere Ende des Sensorelements frei auskragt. Bei dieser Ausführungsform ist das Sensorelement als Kragteil ausgebildet. Durch die Verbindung des Sensorelements an nur einer Seite mit dem Basiselement ist es möglich, das freistehende Ende in unterschiedlichen Formen auszuführen. Dadurch können die mechanischen Eigenschaften des Sensors an unterschiedliche Eigenschaften des zu messenden elektrischen Feldes, beispielsweise hinsichtlich eines elektrischen Gleichfeldes oder eines niederfrequenten Wechselfeldes, oder an unterschiedliche Einsatzbedingungen, beispielsweise für eine mobile Anwendung, angepasst werden.

In einer weiteren Ausführungsform weist das Sensorelement eine T-, U- oder balkenförmige Grundform auf, wobei an der T-, U- oder balkenförmigen Grundform eine Interdigitalstruktur ausgebildet sein kann. Die T-förmige Grundstruktur ermöglicht es, die Spaltlänge zwischen der Kopplungsstrecke und somit die Kapazität zu erhöhen, ohne die mechanischen Eigenschaften des Sensors, insbesondere die Resonanzfrequenz, zu verändern. Auch die U-förmige Ausführungsform hat zum Ziel, die Kapazität durch die Verlängerung der Kopplungsstrecke zu erhöhen. Die Balkenstruktur ist konstruktiv besonders einfach, wodurch die Fertigung des Sensors erleichtert wird. Um die Kapazität bei diesen Ausführungsformen zu erhöhen, ist es vorteilhaft, wenn das Sensorelement und das Gegenelement eine Interdigitalstruktur aufweisen.

Hinsichtlich einer besonders einfachen, stabilen und kostengünstigen Ausführung kann das Gegenelement einteilig mit dem Basiselement ausgebildet sein. Bei dieser Ausführungsform bildet das Gegenelement daher einen Abschnitt des Basiselements.

In einer weiteren Ausführungsform ist das Gegenelement beweglich am Basiselement gelagert. Dadurch kann die mechanisch unabhängige Auslenkung von Gegen- und Sensorelement für die Ermittlung der elektrischen Feldstärke herangezogen werden. Vorteilhafterweise kann so eine höhere Genauigkeit der Messung erzielt werden. Weiters kann eine Fehlererkennung durchgeführt werden.

In einer bevorzugten Ausführungsform weist das Sensorelement zwei elektrische Leiter und das Gegenelement zwei elektrisch leitfähige Kopplungsbereiche auf, wobei sich die Kopplungsbereiche am Gegenelement benachbart der Kopplungsabschnitte der elektrischen Leiter am Sensorelement erstrecken. Durch diese Ausführungsform entstehen zwei Kapazitäten, die beispielsweise an gegenüberliegenden Seiten des Sensorelements angeordnet sein können. Dadurch ist es möglich, die beiden Kopplungsabschnitte, in denen jeweils eine Ladung eingeprägt ist, am Sensorelement örtlich voneinander zu trennen und dennoch einen großen Kapazitätswert beizubehalten. Außerdem können die Flächen von Kopplungsabschnitt und Kopplungsbereich reduziert werden, wodurch die Verzerrung des zu messenden elektrischen Feldes minimiert wird.

In einer besonders bevorzugten Ausführungsform ist der elektrische Leiter am Sensorelement mit einer weiteren Spannungsquelle, insbesondere einer Wechselstrom-Spannungsquelle, verbunden. Bei dieser Ausführungsform wird die Ladung durch die weitere Spannungsquelle in den Kopplungsabschnitt des Sensorelements eingeprägt. Vorzugsweise ist das so am Kopplungsabschnitt angelegte Potenzial unterschiedlich zu jenem des benachbarten Kopplungsbereiches des Gegenelements. Durch die entstehende Potenzialdifferenz zwischen dem Kopplungsabschnitt am Sensorelement und dem Kopplungsbereich am Gegenelement in Kombination mit der kapazitiven Kopplung weist der Kopplungsabschnitt des Sensorelements eine größere Ladung auf, was die Messgenauigkeit des Sensors erhöht.

In einer weiteren bevorzugten Ausführungsform weist das Sensorelement zwei elektrische Leiter auf, welche mit weiteren Spannungsquellen unterschiedlichen Vorzeichens verbunden sind. Diese Ausführungsform weist eine kapazitive Kopplung der beiden elektrischen Leiter auf dem Sensorelement auf, was eine Erhöhung der eingeprägten Ladung zur Folge hat. Vorzugsweise ist diese Ausführungsform damit verbunden, dass das Sensorelement an zwei gegenüberliegenden Seiten mit dem Basiselement verbunden ist, und sich die beiden Kopplungsabschnitte am Sensorelement auf gegenüberliegenden Längsseiten (bezogen auf die Verbindungslinie zwischen den beiden Verbindungen des Sensorelements mit dem Basiselement) befinden. Durch die Verbindung der elektrischen Leiter mit Spannungsquellen unterschiedlichen Vorzeichens sind in den Kopplungsabschnitten Ladungen unterschiedlichen Vorzeichens eingeprägt. Wenn sich das Sensorelement in einem elektrischen Feld befindet, wirken auf die unterschiedlichen Ladungen unterschiedliche Kräfte und es kommt zu einer rotatorischen Auslenkung des Sensorelements um die Verbindungslinie. Ein Vorteil einer solchen Rotation proportional zur elektrischen Feldstärke liegt darin, dass bei einer überlagerten Auslenkung durch eine translatorische Bewegung, insbesondere Beschleunigung, des gesamten Sensorelements, dieser Anteil leichter von dem zur Feldstärke proportionalen Anteil getrennt werden kann. Vorzugsweise sind bei dieser Ausführung die Kopplungsbereiche am Gegenelement derart mit der Spannungsquelle verbunden, dass jeweils benachbarte Kopplungsbereiche am Gegenelement und Kopplungsabschnitte am Sensorelement unterschiedliche Potenziale aufweisen. Auch hier führt die so gebildete Potenzialdifferenz in Kombination mit der erfindungsgemäßen kapazitiven Kopplung zu erhöhten Ladungsdichten in den Kopplungsabschnitten des Sensorelements.

In einer weiteren Ausführungsform ist die weitere Spannungsquelle dazu eingerichtet, eine Ladung im elektrischen Leiter des Sensorelements durch Influenz einzuprägen. Bei dieser Ausführungsform sind bevorzugt zwei Kopplungsbereiche am Gegenelement vorgesehen, in die mit der verbundenen Spannungsquelle unterschiedliche Potenziale eingeprägt sind. Bevorzugt sind zwei Kopplungsabschnitte am Sensorelement vorgesehen, welche vorzugsweise die gleiche Form und die gleichen Längen wie die elektrisch leitfähigen Kopplungsbereiche des Gegenelements aufweisen und elektrisch miteinander verbunden sind. Die Kopplungsabschnitte des Sensorelements befinden sich im elektrischen Feld der Kopplungsbereiche des Gegenelements, wodurch, aufgrund der kapazitiven Kopplung eine Ladungsträgerverschiebung hervorgerufen wird. Auf diese Weise wird in den einen Kopplungsabschnitt eine positive Ladung und in den anderen Kopplungsabschnitt eine negative Ladung eingeprägt. Bei dieser Ausführungsform ist es nicht nötig, elektrische Leiter über die Verbindungsstellen des Sensorelements mit dem Basiselement nach außen zu führen, so dass die Verbindungselemente besonders dünn ausgeführt werden können. Dadurch kann eine geringere Rückstellkraft der federnden Lagerung erzielt werden, wodurch eine größere Auslenkung bei gleicher Feldstärke herbeigeführt werden kann.

Bei einer Ausführungsform ist eine Vakuumeinheit zur Anordnung des Sensorelements und des Gegenelements in einem Vakuum vorgesehen. Um die Messgenauigkeit für geringe Feldstärken zu erhöhen, ist es vorteilhaft, hohe Spannungen am Kopplungsabschnitt des Sensorelements und am Kopplungsbereich des Gegenelements anzubringen. Eine weitere Möglichkeit besteht darin, die Breite des Spaltes zwischen Sensorelement und Gegenelement zu verringern. Durch diese Maßnahmen wird jedoch die Gefahr eines Durchschlages zwischen den benachbarten und mit verschiedenen Potenzialen versehenen Bereichen erhöht. Die Ausführungsform mit Vakuumeinheit minimiert in beiden Fällen das Risiko eines Durchschlages und erlaubt somit Messungen mit höherer Genauigkeit.

Vorzugsweise ist die Auswerteeinheit zur optischen, piezoelektrischen, piezoresistiven, resistiven oder kapazitiven Erfassung der Auslenkung des Sensorelements eingerichtet. Mit einer optischen Auswerteeinheit ist es möglich, auch kleinste Bewegungen noch sehr genau zu erfassen. Besonders bevorzugt werden dabei interferometrische Messmethoden verwendet. Eine weitere Möglichkeit besteht darin, die Auslenkung des Sensorelements aus der Kapazität zwischen dem Sensorelement und dem Gegenelement zu ermitteln. Durch die Abhängigkeit der Kapazität von der relativen Lage des Sensorelements zum Gegenelement, und damit von der Auslenkung, kann durch die Erfassung der Kapazität auf die zu messende Feldstärke geschlossen werden. Zur Integration einer Auswerteeinheit in den Sensor können weiters piezoresistive oder piezoelektrische Materialien an Stellen des Sensors vorgesehen sein, welche in der Messposition eine Verformung aufweisen. Durch die Messung der Spannung aufgrund der Verformung des piezoelektrischen Materials oder durch die Widerstandsänderung am piezoresistiven Material kann auf die Auslenkung und somit auf die zu messende elektrische Feldstärke geschlossen werden.

Die Erfindung wird nachfolgend anhand von besonders bevorzugten Ausführungsbeispielen, auf die sie jedoch nicht beschränkt sein soll, und unter Bezugnahme auf die Zeichnungen noch weiter erläutert.

Fig. 1a bis 1c zeigen eine erste Ausführungsform eines erfindungsgemäßen Sensors, bei welcher eine kapazitive Kopplung zwischen einem beweglichen Sensorelement und einem statischen Gegenelement vorgesehen ist.

Fig. 1d zeigt eine weitere Ausführungsform des Sensors, bei welcher die Ladung im Sensorelement durch Influenz eingeprägt wird.

Fig. 1e zeigt eine Variante des Sensors der Fig. 1a bis 1c mit einer Interdigitalstruktur.

Fig. 1f und Fig. 1g zeigen eine weitere Ausführungsform des Sensors, bei welcher das Sensorelement im äußeren elektrischen Feld seitlich (transversal) verschoben wird.

Fig. 2a zeigt eine weitere Ausführungsform des Sensors, bei welcher ein balkenförmiges Sensorelement vorgesehen ist.

Fig. 2b zeigt eine Variante des Sensors nach Fig. 2a mit einer Interdigitalstruktur.

Fig. 3a zeigt eine weitere Ausführungsform des Sensors mit einem balkenförmigen Sensorelement und nur einem Kopplungsabschnitt.

Fig. 3b zeigt den Sensor nach Fig. 3a in einer Variante mit Interdigitalstruktur.

Fig. 4a bis 4c zeigen verschiedene Ausführungsformen des Sensors mit einem U-förmigen Sensorelement, welches einseitig mit dem Basiselement verbunden ist.

Fig. 5a und 5b zeigen die Sensoren der Fig. 4a bzw. Fig. 4c in einer Variante mit Interdigitalstruktur.

Fig. 6a zeigt eine Ausführungsform des Sensors mit einem balkenförmigen Sensorelement, welches einen Kopplungsabschnitt aufweist und einseitig mit dem Sensorelement verbunden ist.

Fig. 6b zeigt den Sensor nach Fig. 6a in einer Variante mit Interdigitalstruktur.

Fig. 7a zeigt eine Ausführungsform des Sensors mit einem balkenförmigen Sensorelement und einem beweglich am Basiselement gelagerten, balkenförmigen Gegenelement.

Fig. 7b zeigt den Sensor der Fig. 7a in einer Variante mit Interdigitalstruktur.

Fig. 8a zeigt eine Ausführungsform des Sensors mit einem T-förmigen Sensorelement, welches einseitig mit dem Basiselement verbunden ist.

Fig. 8b zeigt den Sensor der Fig. 8A in einer Variante mit Interdigitalstruktur.

Fig. 9a und 9b zeigen zwei Ausführungsvarianten einer Auswerteeinheit für die Erfassung der Auslenkung des Sensorelements.

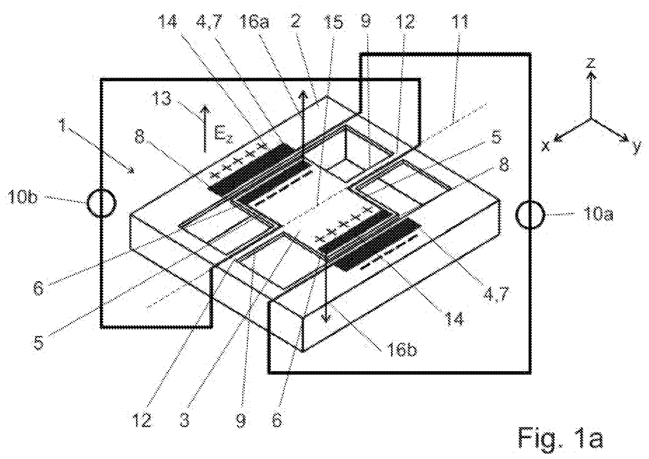

Figur 1a zeigt eine Ausführungsform eines Sensors 1 zur Messung eines äußeren elektrischen Feldes, insbesondere eines elektrischen Gleichfeldes. Der Sensor 1 weist in der gezeigten Variante ein Basiselement 2, ein Sensorelement 3 und zwei Gegenelemente 4 beidseits des Sensorelements 3 auf. Am Sensorelement 3 sind zwei elektrische Leiter 5 aufgebracht, die jeweils einen Kopplungsabschnitt 6 ausbilden. Die Gegenelemente 4 weisen elektrisch leitfähige Kopplungsbereiche 7 auf, die zur kapazitiven Kopplung mit den Kopplungsabschnitten 6 des Sensorelements 3 eingerichtet sind. Der Kopplungsbereich 7 am Gegenelement 4 und der Kopplungsabschnitt 6 am Sensorelement 3 verlaufen benachbart und durch einen Spalt 8 voneinander getrennt. Das Sensorelement 3 ist mit dem Basiselement 2 über elastische Verbindungen 9 verbunden. In der gezeigten Ausführung ergibt sich die elastische Lagerung daraus, dass das Sensorelement 3 dünner, insbesondere um ein Mehrfaches dünner, als das Basiselement 2 ist. Die Kopplungsbereiche 7 sind über Verbindungsleitungen mit einer Spannungsquelle 10a verbunden. In der dargestellten Ausführungsform sind die Kopplungsabschnitte 6 über weitere Verbindungsleitungen mit einer weiteren Spannungsquelle 10b verbunden. Je nach Ausführung kann die Spannungsquelle 10a ident zur weiteren Spannungsquelle 10b sein. Beispielsweise können im Betrieb an einen der Kopplungsbereiche 7 der positive Ausgang der Spannungsquelle 10a und an den anderen Kopplungsbereich 7 der negative Ausgang der Spannungsquelle 10b angeschlossen sein. Die Kopplungsabschnitte 6 des Sensorelements 3 sind dabei mit derselben Spannungsquelle 10a so verbunden, dass jeweils ein benachbarter Kopplungsbereich 7 und Kopplungsabschnitt 6 auf unterschiedlichem Potenzial liegen. Durch die kapazitive Kopplung der nebeneinander verlaufenden Kopplungsbereiche 7 und Kopplungsabschnitte 6 und die angelegte Spannung der Spannungsquelle 10a entsteht eine Ladung in den Kopplungsabschnitten 6 gemäß der Formel

$$Q = C \times U.$$

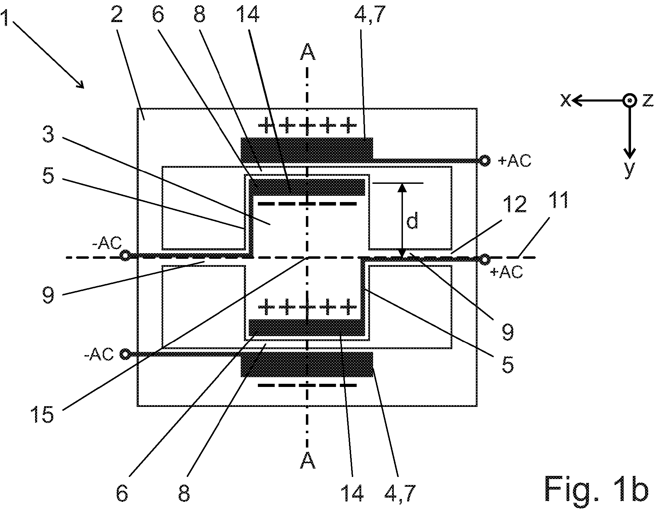

Durch die elastischen Verbindungen 9 kann sich das Sensorelement 3 um eine Verbindungsachse 11 zwischen den Verbindungsstellen 12 verdrehen. Befindet sich der Sensor 1 nun in einem zu messenden elektrischen Feld 13, wirken auf die in den Kopplungsabschnitten 6 eingeprägten Ladungsträger die Kräfte 16a und 16b. Da in den beiden Kopplungsabschnitten 6 Ladungen unterschiedlichen Vorzeichens eingeprägt sind, wirkt die Kraft 16a auf den einen Kopplungsabschnitt 6 in Richtung des elektrischen Feldes 13, die Kraft 16b auf den anderen Kopplungsabschnitt 6 dem elektrischen Feld 13 entgegen. Durch die Kräfte 16a und 16b und den Abstand d (Fig. 1b) zum Ladungsträgerkonzentrationsschwerpunkt 14 wirkt ein Moment auf das Sensorelement 3. Aufgrund der Anordnung des Kopplungsbereichs 7 seitlich außerhalb des Kopplungsabschnittes 6 befindet sich der Ladungsträgerschwerpunkt 14 im äußeren Randbereich des Kopplungsabschnitts 6 auf Seite des benachbarten Kopplungsbereichs 7 des Gegenelements 4, wodurch der Abstand d (vgl. Fig. 1b) und somit das Moment maximal sind. Aufgrund der kapazitiven Kopplung zwischen dem Kopplungsbereich 7 am Gegenelement 4 und dem Kopplungsabschnitt 6 am Sensorelement 3 kann auf eine kapazitive Kopplung der beiden Kopplungsabschnitte 6 am Sensorelement 3 verzichtet werden. Somit können die Kopplungsabschnitte 6 nur an den Rändern des Sensorelements 3, hin zu den Spalten 8, ausgebildet sein, wobei der zentrale Bereich 15 des Sensorelements 3 frei elektrisch leitfähigem Material ist. Durch diese Reduktion der leitfähigen Materialien im Bereich des zu messenden elektrischen Feldes 13 wird eine Verzerrung des elektrischen Feldes vermindert.

Fig. 1b zeigt den Sensor 2 aus Figur 1a in einer Draufsicht. Zur Erklärung der Bezugszeichen sei auf die Ausführungen zu Fig. 1a verwiesen.

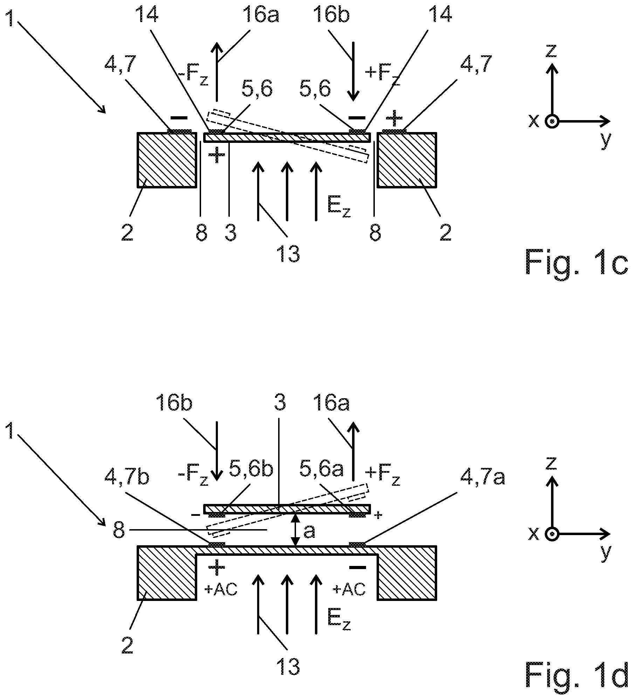

Fig. 1c zeigt einen Schnitt durch den Sensor 1 entlang der Schnittlinie A-A (siehe Fig. 1b). Hier sind die Kräfte 16a und 16b veranschaulicht, die in einem elektrischen Feld 13 auf das Sensorelement 3 wirken. Durch Ladungen unterschiedlichen Vorzeichens in den Kopplungsabschnitten 6 wirken die Kräfte 16a und 16b in entgegengesetzte Richtungen, parallel zum elektrischen Feld 13. Die Kräfte 16a und 16b bewegen das Sensorelement 3 von der mit durchgezogen Linien veranschaulichten Ruheposition in die mit strichlierten Linien angedeutete Messposition. Die Messposition hängt damit von der Stärke des elektrischen Feldes 13 und der Rückstellkraft der elastischen Verbindung 9 ab.

Figur 1d zeigt einen erfindungsgemäßen Sensor 1 in einer weiteren Ausführungsform, wobei das Sensorelement 3 in einem Normalabstand a in einer Ebene über dem Gegenelement 4 angeordnet ist. Die Kopplungsbereiche 7a und 7b sind jeweils mit der Spannungsquelle 10 verbunden, wobei jeder der beiden Kopplungsbereiche 7a, 7b mit einem anderen Ausgang der Spannungsquelle 10a verbunden ist. Dadurch stellt sich zwischen den beiden Kopplungsbereichen 7a und 7b eine Potenzialdifferenz ein. Auf dem Sensorelement 3 sind, deckungsgleich mit den beiden Kopplungsbereichen 7a, 7b am Gegenelement 4, Kopplungsabschnitte 6a, 6b angeordnet, welche miteinander elektrisch verbunden sind. Die beiden Kopplungsabschnitte 6 sind mit den beiden Kopplungsbereichen 7a, 7b kapazitiv gekoppelt. Das elektrische Koppelfeld, das zwischen den Kopplungsbereichen 7a, 7b durch die Potenzialdifferenz gebildet ist, ruft in den, im Koppelfeld befindlichen, Koppelabschnitten 6a, 6b eine Ladungsträgerverschiebung hervor, so dass in den beiden Koppelabschnitten 6a, 6b gegenpolige Ladungen entstehen (Influenz). Die Größe der influenzierten Ladung hängt dabei von der an den Kopplungsbereichen 7a, 7b angelegten Spannung und der durch die kapazitive Kopplung gebildeten Kapazität ab. Die Entstehung einer Auslenkung ist dabei äquivalent zum Sensor 1 aus Fig. 1a bis 1c, so dass auf die Ausführungen oben verwiesen werden kann. Auch bei anderen Sensorgeometrien, insbesondere gemäß Fig. 1c, können die Ladungsträger am Sensorelement 3 durch Influenz eingeprägt werden.

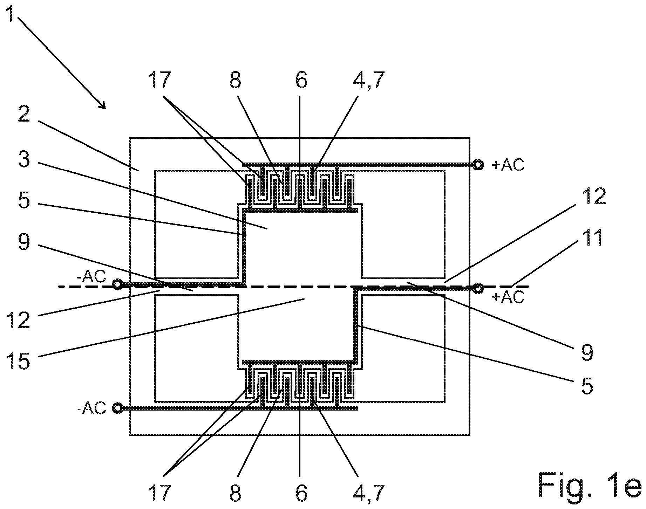

Fig. 1e zeigt eine Variante des Sensors 1 gemäß den Fig. 1a bis 1c. Bei dieser Ausführungsvariante bilden der Kopplungsbereich 7 und der Kopplungsabschnitt 6 eine Interdigitalstruktur aus. Dazu sind am Sensorelement 3 und am Gegenelement 4 jeweils mehrere Finger 17 vorgesehen, welche ineinandergreifen. Durch die Ausbildung dieser Interdigitalstruktur kann die Länge des Spalts 8, der den Kopplungsabschnitt 6 und den Kopplungsbereich 7 voneinander trennt, verlängert werden, ohne die mechanischen Eigenschaften des Sensorelements 3 nennenswert zu beeinflussen. Durch die Verlängerung des Spalts 8 kann die Koppelkapazität, die zwischen dem Kopplungsabschnitt 6 und dem Kopplungsbereich 7 ausgebildet ist, vergrößert und damit die Messgenauigkeit erhöht werden.

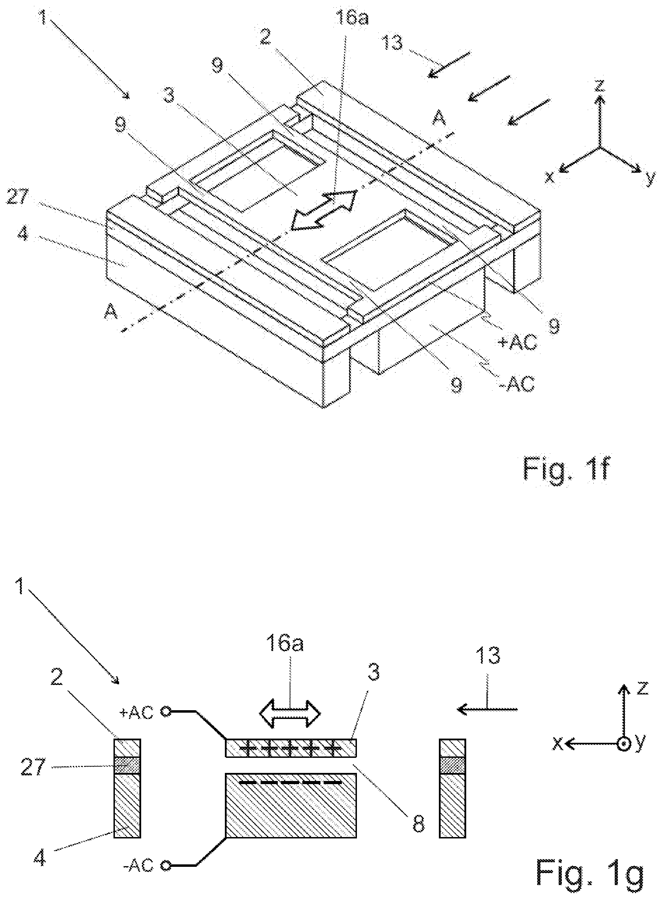

Fig. 1f zeigt eine weitere Ausführungsform des Sensors 1, bei welcher das Sensorelement 3 in einem Normalabstand über dem Gegenelement 4 angebracht ist. Das Sensorelement 3 befindet sich dabei in derselben Ebene wie das Basiselement 2 und ist mit diesem über elastische Verbindungen 9 verbunden. In dieser Ausführungsform sind das Sensorelement 3, das Basiselement 2 und die elastischen Verbindungen 9 aus leitfähigem Material hergestellt und elektrisch verbunden. Das Gegenelement 4 ist ebenso aus einem leitfähigen Material hergestellt und ist durch einen Isolator 27 mit dem Basiselement 2 verbunden, von diesem jedoch elektrisch isoliert. Die Spaltbreite des Spalts 8 (siehe Fig. 1g) ist dabei über die Dicke des Isolators 27 festgelegt. Der Sensor 1 ist bei dieser Ausführungsform dafür vorgesehen, so in dem elektrischen Feld 13 positioniert zu werden, dass die Feldlinien parallel zum Sensorelement 3 und quer zu den elastischen Verbindungen 9 verlaufen. Das Gegenelement 4 ist mit einer Spannungsquelle 10a verbunden (hier nicht dargestellt), das Sensorelement 3 mit einer weiteren Spannungsquelle 10b (ebenfalls hier nicht dargestellt). Beispielsweise können das Gegenelement 4 und das Sensorelement 3 auch mit unterschiedlichen Polen derselben Spannungsquelle 10a verbunden sein. Durch die Spannungsquelle 10a wird in das Sensorelement 3 nun eine Ladung eingeprägt. Durch die kapazitive Kopplung mit dem Gegenelement 4 wird diese Ladung erhöht. Wenn sich der Sensor 1 nun in einem elektrischen Feld 13 befindet, wird eine Kraft 16a auf die Ladung im Sensorelement 3 ausgeübt, welche eine Auslenkung, in diesem Fall eine transversale Verschiebung, des Sensorelements 3 parallel zum elektrischen Feld 13 hervorruft. Durch die Messung dieser Auslenkung kann auf die Stärke des elektrischen Feldes 13 geschlossen werden.

Fig. 1g zeigt den Sensor 1 aus Figur 1f in einem Querschnitt entlang der Linie A-A.

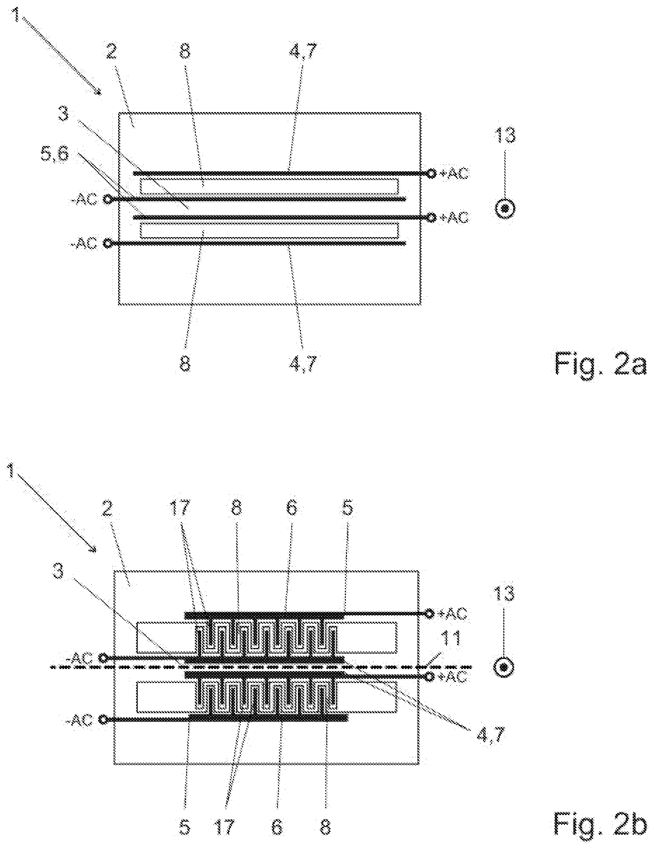

Fig. 2a zeigt eine weitere Ausführungsform des Sensors 1, bei welcher das Sensorelement 3 als Balken ausgeführt ist. Auf dem Gegenelement 4 sind zwei Kopplungsbereiche 7 und auf dem Sensorelement 3 zwei Kopplungsabschnitte 6 vorgesehen. Die elektrische Beschaltung kann wie bei der Ausführungsform der Fig. 1a bis 1b sein.

Fig. 2b zeigt eine Variante des Sensors der Fig. 2a, bei welcher die Kopplungsabschnitte 6 am Sensorelement 3 und die Kopplungsbereiche 7 am Gegenelement 4 eine Interdigitalstruktur ausbilden. Diese Interdigitalstruktur erhöht einerseits die Kapazität des Sensors zwischen Kopplungsabschnitt 6 und Kopplungsbereich 7, andererseits wird der Ladungsträgerschwerpunkt weiter nach außen (weg von der strichliert eingezeichneten Verbindungsachse) verschoben und so das auf das Sensorelement 3 wirkende Moment erhöht wird. Gleichzeitig bleibt die einfache Herstellung und die geringe Anfälligkeit auf externe Einflüsse weitestgehend erhalten.

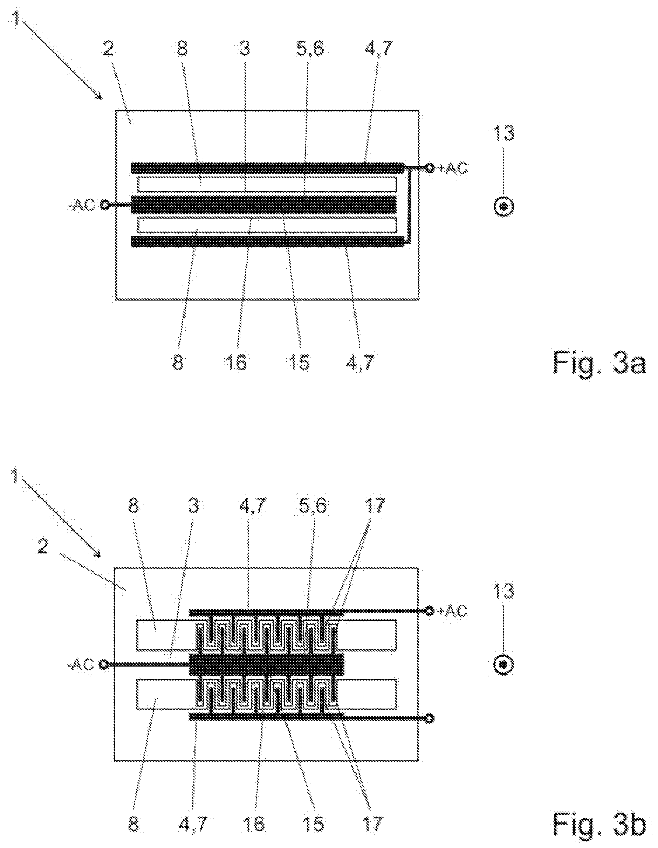

Fig. 3a zeigt einen Sensor 1 mit einem Sensorelement 3, das an zwei gegenüberliegenden Seiten mit dem Basiselement 2 verbunden ist, jedoch nur einen Kopplungsabschnitt 6 aufweist. Am Gegenelement 4 sind zwei Kopplungsbereiche 7 ausgebildet, die miteinander elektrisch verbunden sind. Die Kopplungsbereiche 7 sind mit einer Spannungsquelle 10a verbunden. Bei dieser Ausführungsform ist der Kopplungsabschnitt 6 am Sensorelement 3 mit einer weiteren Spannungsquelle 10b anderen Potenzials oder auch mit einem anderen Ausgang der Spannungsquelle 10a verbunden. Die kapazitive Kopplung tritt hier zwischen dem Kopplungsabschnitt 6 am Sensorelement 3 und den beiden Kopplungsbereichen 7 am Gegenelement 4 auf. Wenn sich der Sensor 1 in einem elektrischen Feld 13 befindet, wirkt auf die im Kopplungsabschnitt 6 eingeprägte Ladung eine Kraft 16, die zu einer Ausbeulung des zentralen Bereiches 15 des Sensorelementes 3 führt. Der Vorteil dieser Ausführungsform liegt wieder in der einfachen Herstellbarkeit und der Robustheit gegenüber externen mechanischen Einflüssen. Da hier eine transversale Bewegung die maßgebende Größe ist, wirkt sich ein externer Einfluss in Form einer Rotation auf das Messergebnis nicht wesentlich aus.

Fig. 3b zeigt im Wesentlichen denselben Sensor 1 wie Fig. 3a, jedoch bilden hier die Kopplungsbereiche 7 am Gegenelement 4 und die Kopplungsabschnitt 6 am Sensorelement 3 eine Interdigitalstruktur aus, die die Kapazität des Sensors und somit die Messgenauigkeit erhöht.

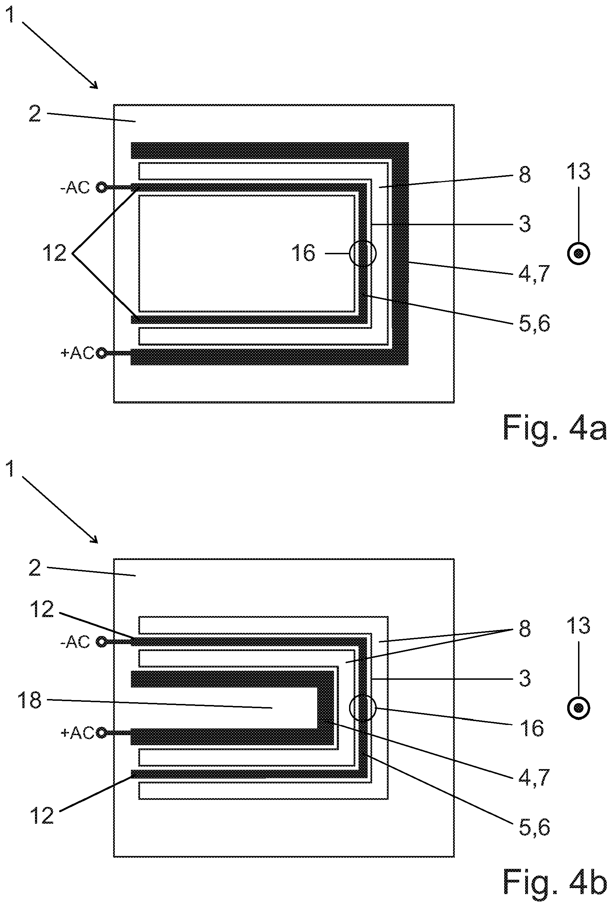

Fig. 4a zeigt einen Sensor 1 mit einem frei auskragenden Sensorelement 3, das einseitig über zwei Verbindungsstellen 12 mit dem Basiselement 2 verbunden ist. Das Sensorelement 3 ist im Wesentlichen U-förmig. Bei dieser Ausführungsform erstreckt sich der Kopplungsabschnitt 6 im Wesentlichen über den gesamten U-förmigen Außenumfang des Sensorelements 3. Zur kapazitiven Kopplung erstreckt sich der Kopplungsbereich 7 am Gegenelement 4 parallel zum Kopplungsabschnitt 6 am Sensorelement 3. Der Kopplungsbereich 7 ist mit der Spannungsquelle 10a verbunden. Bei dieser Ausführungsform ist der Kopplungsabschnitt 6 am Sensorelement 3 mit der weiteren Spannungsquelle 10b anderen Potenzials oder auch mit einem weiteren Ausgang der Spannungsquelle 10a verbunden. Durch die Potenzialdifferenz wird in den Kopplungsabschnitt 6 des Sensorelements 3 eine Ladung eingeprägt. Befindet sich das Sensorelement 3 in einem elektrischen Feld 13, wirkt auf die Ladungsträger eine Kraft 16, die eine Aufwärts- bzw. Abwärtsbiegung des Sensorelements 3 hervorruft.

Fig. 4b zeigt eine abgewandelte Ausführungsform des Sensors 1. Hier befindet sich das Gegenelement 4 im Inneren 18 des Sensorelements 3. Auf das Gegenelement 4 ist der Kopplungsbereich 7 zur kapazitiven Kopplung mit dem Kopplungsabschnitt 6 des Sensorelements 3 aufgebracht. Die elektrische Beschaltung und Auslenkung des Sensorelements 3 entspricht der Ausführungsform der Fig. 4a. Der Vorteil der Ausführungsform der Fig. 4b liegt insbesondere darin, dass die Fläche des elektrisch leitfähigen Kopplungsbereichs 7 vergleichsweise klein ist und dadurch eine geringere Feldverzerrung als bei der Ausführungsform nach Fig. 4a auftritt.

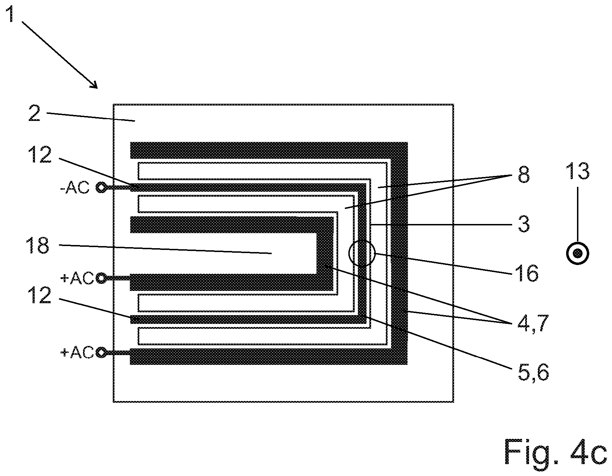

Fig. 4c zeigt eine Ausführungsvariante, bei welcher sowohl innerhalb des Sensorelements 3 (wie bei Fig. 4b) als auch außerhalb des Sensorelements 3 (wie bei Fig. 4a) jeweils ein Gegenelement 4 ausgebildet ist. Beide Gegenelemente 4 weisen jeweils einen Kopplungsbereich auf. Die beiden Kopplungsbereiche 7a, 7b sind mit demselben Potenzial der Spannungsquelle 10a verbunden. Diese Ausführungsform erhöht die Kapazität des Sensors, was eine genauere Messung ermöglicht.

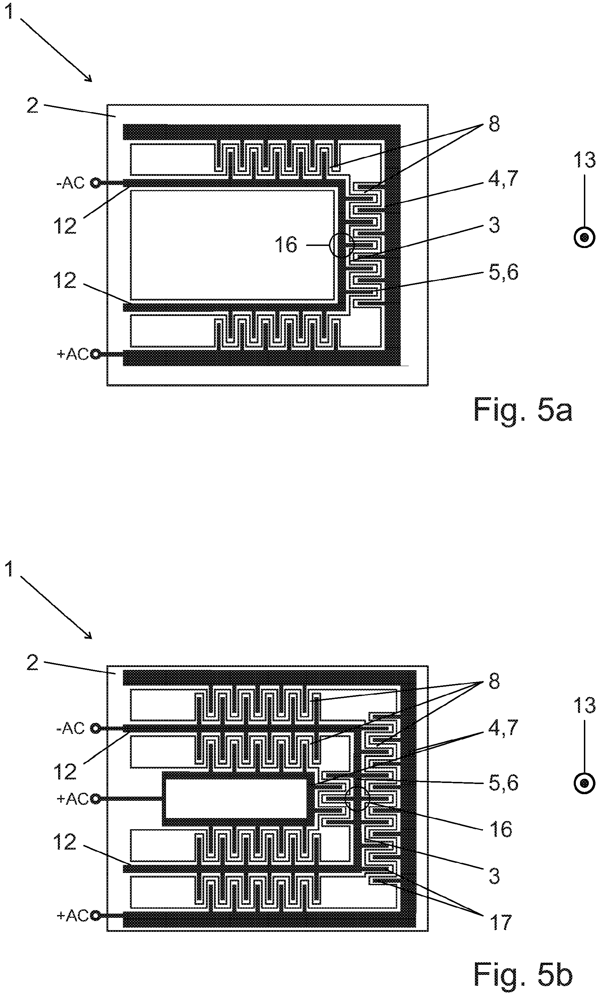

Die Figuren 5a und 5b zeigen Fig. 4a bzw. Fig. 4c entsprechende Ausführungsformen, wobei hier der Kopplungsabschnitt 6 am Sensorelement 3 und der Kopplungsbereich 7 am Gegenelement 4 eine Interdigitalstruktur ausbilden. Dabei sind am Sensorelement 3 Finger 17 ausgebildet, die sich zwischen entsprechend gestalteten Fingern 17 am Gegenelement 4 erstrecken. Der Kopplungsbereich 7 und der Kopplungsabschnitt 6 sind auf die jeweiligen Finger 17 erweitert. Durch den so länger ausgeführten Spalt 8 wird die Kapazität der Anordnung und somit die Messgenauigkeit erhöht.

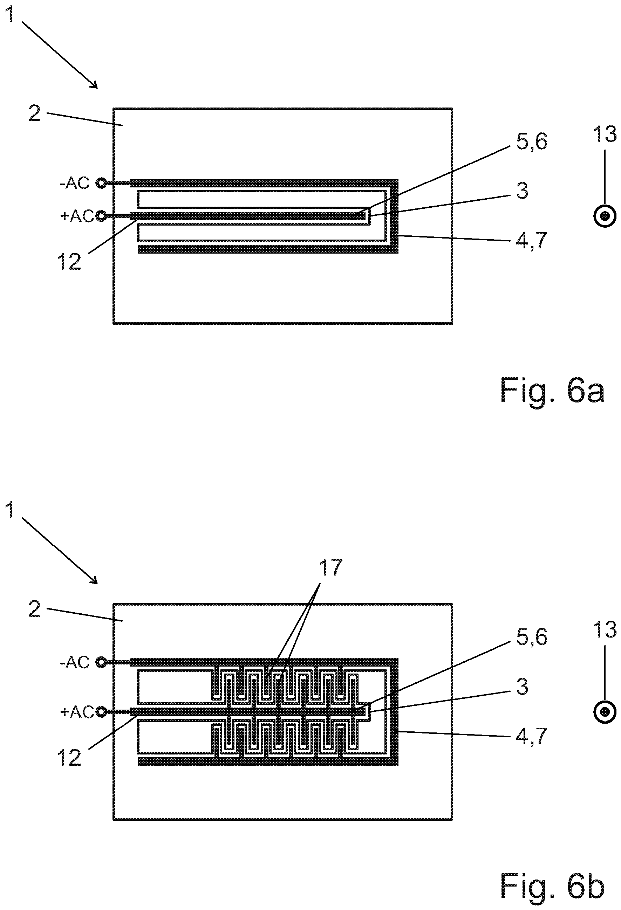

Fig. 6a zeigt einen Sensor 1, der ein balkenförmiges Sensorelement 3 aufweist, das nur an einer Seite an einer Verbindungsstelle 12 mit dem Basiselement 2 verbunden ist, wobei das andere Ende des Sensorelements 3 frei auskragt. Am Sensorelement 3 ist der elektrisch leitende Kopplungsabschnitt 6 aufgebracht. Das Sensorelement 3 wird vom Gegenelement 4 umgeben, auf dem der Kopplungsbereich 7 aufgebracht ist, welcher bei dieser Ausführung in Draufsicht U-förmig ist. Der Kopplungsbereich 7 ist mit der Spannungsquelle 10a verbunden. Bei dieser Ausführungsform wird der Kopplungsabschnitt 6 des Sensorelements 3 mit der weiteren Spannungsquelle 10b verbunden, so dass Kopplungsabschnitt 6 und Kopplungsbereich 7 auf unterschiedlichen Potenzialen liegen. Alternativ kann der Kopplungsabschnitt auch an einen weiteren Ausgang anderen Potenzials der Spannungsquelle 10a angeschlossen sein. Dadurch wird im Kopplungsabschnitt 6 am Sensorelement 3 eine Ladung eingeprägt, die, wenn sich der Sensor 1 in einem zu messenden elektrischen Feld 13 befindet, eine Auslenkung des Sensorelements 3 bewirkt. Der Vorteil dieser Ausführungsform ist die einfache Herstellbarkeit und weiters eine größere Empfindlichkeit durch die nur einseitige Verbindung.

Fig. 6b zeigt eine Fig. 6a entsprechende Ausführungsform, wobei zudem der Kopplungsabschnitt 6 am Sensorelement 3 und der Kopplungsbereich 7 am Gegenelement 4 eine Interdigitalstruktur ausbilden. Dabei sind am Sensorelement 3 und am Gegenelement 4 jeweils Finger 17 ausgebildet, die miteinander verzahnt sind. Der Kopplungsabschnitt 6 und der Kopplungsbereich 7 sind jeweils auf die zugehörigen Finger 17 erweitert.

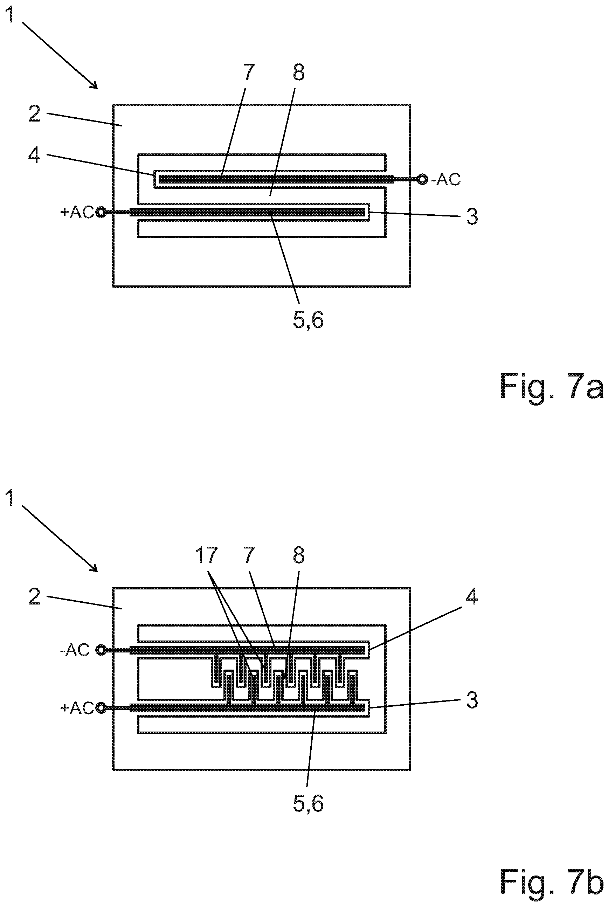

Fig. 7a zeigt eine weitere Ausführungsform des Sensors 1, welcher ein balkenförmiges Sensorelement 3 besitzt, das an einer Seite mit dem Basiselement 2 verbunden ist und auf der anderen Seite frei auskragt. Auf dem Sensorelement 3 ist der Kopplungsabschnitt 6 aufgebracht. Bei dieser Ausführungsform ist auch das Gegenelement 4 mit dem darauf befindlichen Kopplungsbereich 7 beweglich am Basiselement 2 gelagert. Das Gegenelement 4 ist dabei wie das Sensorelement 3 balkenförmig ausgeführt und nur an einer Seite am Basiselement 2 gelagert, wobei die andere Seite frei auskragt. Das Gegenelement 4 ist mit der Spannungsquelle 10a verbunden, wobei das Sensorelement 3 mit der weiteren Spannungsquelle 10b anderen Potenzials verbunden ist. Bei dieser Ausführungsform werden sowohl das Sensorelement 3 als auch das Gegenelement 4 in einem elektrischen Feld 13 ausgelenkt. Die Auslenkung der beiden Elemente ist mechanisch unabhängig voneinander. Bei getrennter Erfassung der Auslenkungen können zwei unabhängige Werte pro Messung erhalten werden. Da das Sensorelement 3 und das Gegenelement 4 aufgrund der unterschiedlichen eingeprägten Ladungen in entgegengesetzte Richtungen ausgelenkt werden, kann ein Gleichanteil der Auslenkung, beispielsweise durch eine mechanische Einwirkung, herausgerechnet werden.

Figur 7b zeigt den Sensor nach Fig. 7a, wobei hier der Kopplungsbereich 7 und der Kopplungsabschnitt 6 eine Interdigitalstruktur ausbilden. Das Sensorelement 3 und das Gegenelement 4 weisen dabei ineinandergreifende Finger 17 auf.

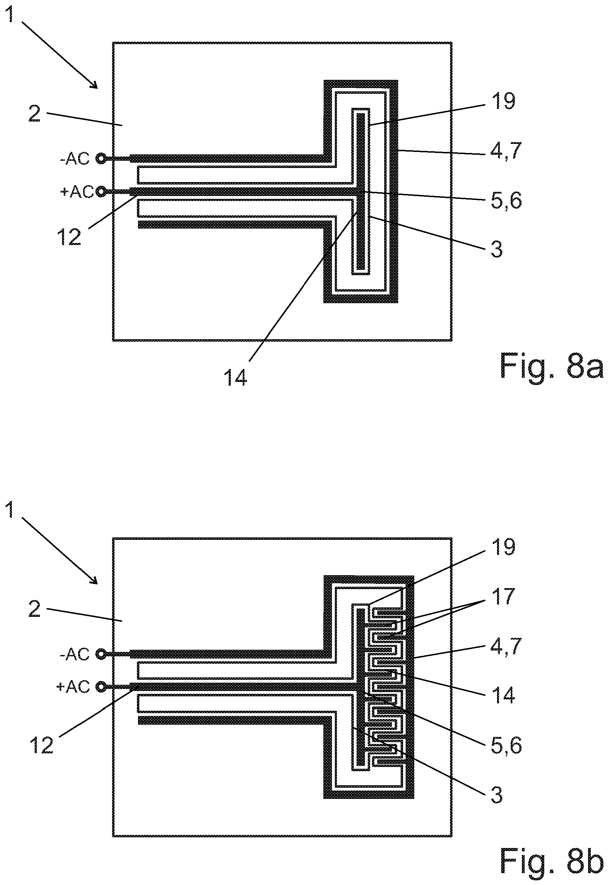

Fig. 8a zeigt eine weitere Ausführungsform des Sensors 1, bei welcher an einem frei auskragenden Ende des Sensorelements 3 eine balkenförmige Querstruktur 19 quer zum übrigen Sensorelement 3 vorgesehen ist. Das Sensorelement 3 weist somit eine T-Form auf. Das Gegenelement 4 ist in dieser Ausführungsform um das Sensorelement 3 herum ausgebildet. Auf dem T-förmigen Sensorelement 3 ist der Kopplungsabschnitt 6 vorgesehen, am Gegenelement 4 der Kopplungsbereich 7. Der Kopplungsbereich 7 ist mit der Spannungsquelle 10a verbunden. Der Kopplungsabschnitt 6 ist mit der weiteren Spannungsquelle 10b oder mit einem weiteren Ausgang der Spannungsquelle 10a verbunden. Durch die zusätzliche Kopplungsstrecke entlang der balkenförmigen Querstruktur 19 des Sensorelements 3 verschiebt sich der Ladungsträgerschwerpunkt 14 in Richtung des frei auskragenden Endes des Sensorelements 3, wodurch das auf das Sensorelement 3 wirkende Moment und somit die Auslenkung und Messgenauigkeit erhöht wird.

Fig. 8b zeigt eine abgewandelte Ausführungsform des Sensors 1 der Fig. 8a, bei welcher zwischen Kopplungsabschnitt 6 und Kopplungsbereich 7 eine Interdigitalstruktur ausgebildet ist. Die Finger 17 sind am Sensorelementes 3 jedoch nur an der durchgehenden Außenkante der balkenförmigen Querstruktur 19 vorgesehen, welche die größte Distanz zur Verbindungsstelle 12 aufweist. Den Fingern 17 des Sensorelements 3 liegen Finger 17 des Gegenelements 4 derart gegenüber, dass die Finger 17 ineinandergreifen und so eine Verzahnung bilden. Durch die Anordnung der Interdigitalstruktur am frei auskragenden Ende des Sensorelements 3 wird der Ladungsträgerschwerpunkt 14 weiter weg von der Verbindungsstelle 12 verschoben, wodurch das auf das Sensorelement 3 wirkende Moment erhöht wird.

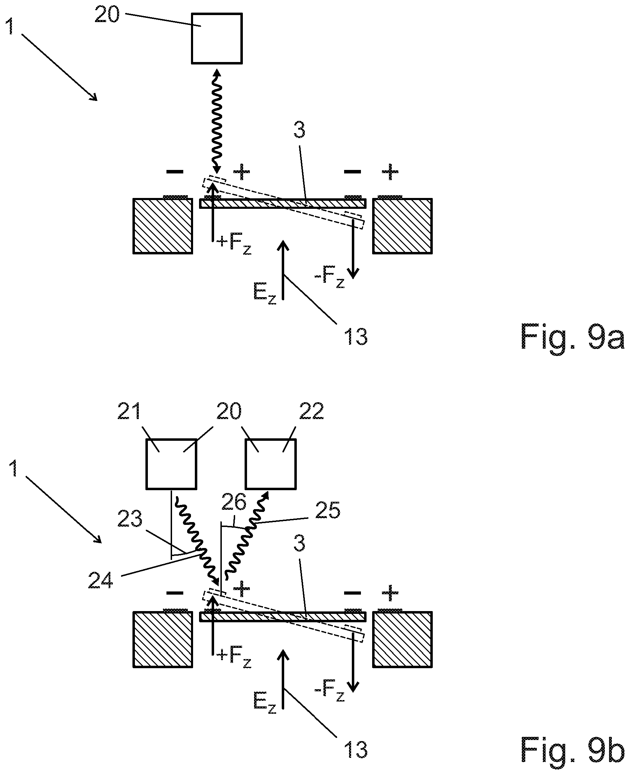

Fig. 9a zeigt eine Ausführungsform des Sensors 1 entsprechend Fig. 1a bis 1c mit einer Auswerteeinheit 20 zur optischen Auswertung der Auslenkung des Sensorelements 3. Die optische Auswerteeinheit 20 befindet sich oberhalb eines äußeren Randes des Sensorelements 3. Die Auswerteeinheit 20 ist dabei so eingerichtet, dass sie den Normalabstand zum Sensorelement 3 erfasst. Ist das Sensorelement 3 von der (mit durchgezogenen Linien veranschaulichten) Ruheposition in eine (mit strichlierten Linien veranschaulichte) Messposition ausgelenkt, verändert sich der Abstand zur Auswerteeinheit 20. Aus dieser Abstandsänderung kann in weiterer Folge die Stärke des elektrischen Feldes 13 berechnet werden. Zur Messung des Abstands kann beispielsweise eine interferometrische Anordnung verwendet werden.

Fig. 9b zeigt einen Sensor 1 mit einer anderen optischen Auswerteeinheit 20, welche aus einem Sender 21 und einem Empfänger 22 besteht. Vom Sender 21 wird unter einem bestimmten Winkel 23 ein Laserstrahl 24 auf das Sensorelement 3 gerichtet. Der Laserstrahl 24 wird vom Sensorelement 3 reflektiert und von einem Empfangsgerät aufgenommen. Das Empfangsgerät liefert ein Signal, das vom Ort abhängt, an dem der reflektierte Laserstrahl 25 auf den Empfänger 22 auftrifft. Durch eine Auslenkung des Sensorelements 3 ändert sich nun der Reflexionswinkel 26, unter welchem der Laserstrahl 24 reflektiert wird und damit der vom Empfänger 22 gemessene Ort. Dadurch kann die Stärke des zu messenden elektrischen Feldes 13 bestimmt werden.

**Patentansprüche**

1. Sensor (1) zum Messen einer elektrischen Feldstärke eines elektrischen Feldes (13), aufweisend:

   ein Basiselement (2),
   ein Sensorelement (3) mit zumindest einem elektrischen Leiter (5), wobei das Sensorelement (3) durch die Wirkung des elektrischen Feldes (13) auf den elektrischen Leiter (5) von einer Ruheposition in eine Messposition (3a) auslenkbar ist,
   eine Auswerteeinheit (20) zur Erfassung der Auslenkung des Sensorelements (3) in der Messposition (3a),
   ein Gegenelement (4) mit zumindest einem elektrisch leitfähigen Kopplungsbereich (7), wobei sich der elektrisch leitfähige Kopplungsbereich (7) am Gegenelement (4) im Ruhezustand des Sensorelements (3) benachbart eines Kopplungsabschnitts (6) des elektrischen Leiters (5) am Sensorelement (3) erstreckt,
   **dadurch gekennzeichnet, dass**

   der elektrisch leitfähige Kopplungsbereich (7) zur kapazitiven Kopplung mit dem Kopplungsabschnitt (6) des elektrischen Leiters (5) am Sensorelement (3) mit einer Spannungsquelle (10a) verbunden ist, wobei die Spannungsquelle (10a) eine Wechselstrom-Spannungsquelle ist.

2. Sensor (1) nach Anspruch 1, **dadurch gekennzeichnet, dass** sich der Kopplungsbereich (7) am Gegenelement (4) parallel zum Kopplungsabschnitt (6) des elektrischen Leiters (5) am Sensorelement (3) erstreckt.

3. Sensor (1) nach Anspruch 1 oder 2, **dadurch gekennzeichnet, dass** der Kopplungsbereich (7) am Gegenelement (4) und der Kopplungsabschnitt (6) am Sensorelement (3) eine Interdigitalstruktur ausbilden.

4. Sensor (1) nach einem der Ansprüche 1 bis 3, **dadurch gekennzeichnet, dass** das Gegenelement (4) in der Ruheposition des Sensorelements (3) in derselben Ebene wie das Sensorelement (3) angeordnet ist.

5. Sensor (1) nach einem der Ansprüche 1 bis 4, **dadurch gekennzeichnet, dass** das Gegenelement (4) in der Ruheposition des Sensorelements (3) parallel und in einem Normalabstand zu dem Sensorelement (3) angeordnet ist.

6. Sensor (1) nach einem der Ansprüche 1 bis 5, **dadurch gekennzeichnet, dass** das Sensorelement (3) an zwei gegenüberliegenden Enden mit dem Basiselement (2) verbunden ist.

7. Sensor nach einem der Ansprüche 1 bis 6, **dadurch gekennzeichnet, dass** das eine Ende des Sensorelements (3) mit dem Basiselement (2) verbunden ist, wobei das andere Ende des Sensorelements (3) frei auskragt.

8. Sensor (1) nach einem der Ansprüche 1 bis 7, **dadurch gekennzeichnet, dass** das Sensorelement (3) eine T-, U- oder balkenförmige Grundform aufweist, wobei an der T-, U- oder balkenförmigen Grundform eine Interdigitalstruktur ausgebildet sein kann.

**9.** Sensor (1) nach einem der Ansprüche 1 bis 8, **dadurch gekennzeichnet, dass** das Gegenelement (4) einteilig mit dem Basiselement (2) ausgebildet ist.

**10.** Sensor (1) nach einem der Ansprüche 1 bis 9, **dadurch gekennzeichnet, dass** das Gegenelement (4) beweglich am Basiselement (2) gelagert ist.

**11.** Sensor (1) nach einem der Ansprüche 1 bis 10, **dadurch gekennzeichnet, dass** das Sensorelement (3) zwei elektrische Leiter (5) und das Gegenelement (4) zwei elektrisch leitfähige Kopplungsbereiche (7) aufweist, wobei sich die Kopplungsbereiche (7) am Gegenelement (4) benachbart der Kopplungsabschnitte (6) der elektrischen Leiter (5) am Sensorelement (3) erstrecken.

**12.** Sensor (1) nach einem der Ansprüche 1 bis 11, **dadurch gekennzeichnet, dass** der elektrische Leiter (5) am Sensorelement (3) mit einer weiteren Spannungsquelle (10b), insbesondere einer Wechselstrom-Spannungsquelle, verbunden ist.

**13.** Sensor (1) nach Anspruch 12, **dadurch gekennzeichnet, dass** das Sensorelement (3) zwei elektrische Leiter (5) aufweist, welche mit weiteren Spannungsquellen (10b) unterschiedlichen Vorzeichens verbunden sind.

**14.** Sensor (1) nach einem der Ansprüche 1 bis 11, **dadurch gekennzeichnet, dass** die Spannungsquelle (10a) dazu eingerichtet ist, eine Ladung im elektrischen Leiter (5) des Sensorelements (3) durch Influenz einzuprägen.

**15.** Verfahren zum Messen einer elektrischen Feldstärke eines elektrischen Feldes (13), mit den Schritten:

Anordnen eines Sensors (1) nach einem der Ansprüche 1 bis 14,
Auslenken des Sensorelements (3) durch die Wirkung des elektrischen Feldes (13) auf den elektrischen Leiter (5) von der Ruheposition in die Messposition, und
Erfassen der Auslenkung des Sensorelements (3) in der Messposition.

**Claims**

**1.** A sensor (1) for measuring an electric field strength of an electric field (13), comprising:

a base element (2),

a sensor element (3) having at least one electrical conductor (5), wherein the sensor element (3) is deflectable from a rest position to a measurement position (3a) by the effect of the electric field (13) on the electrical conductor (5);
an evaluation unit (20) for detecting the deflection of the sensor element (3) in the measurement position (3a); and
a counter element (4) having at least one electrically conductive coupling area (7), wherein, in the rest state of the sensor element (3), the electrically conductive coupling area (7) on the counter element (4) extends adjacent to a coupling section (6) of the electrical conductor (5) on the sensor element (3),
**characterized in that** the electrically conductive coupling area (7) is connected to a voltage source (10a) for capacitive coupling with the coupling section (6) of the electrical conductor (5) at the sensor element (3), wherein the voltage source (10a) is an AC voltage source.

**2.** The sensor (1) according to claim 1, **characterized in that** the coupling area (7) on the counter element (4) extends parallel to the coupling section (6) of the electrical conductor (5) at the sensor element (3).

**3.** The sensor (1) according to claim 1 or 2, **characterized in that** the coupling area (7) on the counter element (4) and the coupling section (6) on the sensor element (3) form an interdigital structure.

**4.** The sensor (1) according to any one of claims 1 to 3, **characterized in that** the counter element (4) is arranged in the same plane as the sensor element (3) when the sensor element (3) is in the rest position.

**5.** The sensor (1) according to any one of claims 1 to 4, **characterized in that** the counter element (4) is arranged parallel to the sensor element (3) and at a normal distance from the sensor element (3) when in the rest position.

**6.** The sensor (1) according to any one of claims 1 to 5, **characterized in that** the sensor element (3) is connected to the base element (2) at two opposite ends.

**7.** The sensor according to any one of claims 1 to 6, **characterized in that** one end of the sensor element (3) is connected to the base element (2) while the other end of the sensor element (3) protrudes freely.

**8.** The sensor (1) according to any one of claims 1 to 7, **characterized in that** the sensor element (3) has a T-, U-, or beam-shaped basic structure, wherein an interdigital structure can be formed on the T-, U-, or beam-shaped basic structure.

**9.** The sensor (1) according to any one of claims 1 to 8, **characterized in that** the counter element (4) is formed in one piece with the base element (2).

**10.** The sensor (1) according to any one of claims 1 to 9, **characterized in that** the counter element (4) is movably mounted on the base element (2).

**11.** The sensor (1) according to any one of claims 1 to 10, **characterized in that** the sensor element (3) has two electrical conductors (5) and the counter element (4) has two electrically conductive coupling areas (7), wherein the coupling areas (7) on the counter element (4) extend adjacent to the coupling sections (6) of the electrical conductors (5) on the sensor element (3).

**12.** The sensor (1) according to any one of claims 1 to 11, **characterized in that** the electrical conductor (5) on the sensor element (3) is connected to an additional voltage source (10b), in particular an AC voltage source.

**13.** The sensor (1) according to claim 12, **characterized in that** the sensor element (3) comprises two electrical conductors (5), which are connected to further voltage sources (10b) having different polarities.

**14.** The sensor (1) according to any one of claims 1 to 11, **characterized in that** the voltage source (10a) is configured to impress a charge into the electrical conductor (5) of the sensor element (3) by induction.

**15.** A method for measuring an electric field strength of an electric field (13), comprising the steps of:

arranging a sensor (1) according to any one of claims 1 to 14;
deflecting the sensor element (3) from the rest position to the measurement position by the effect of the electric field (13) on the electrical conductor (5); and
detecting the deflection of the sensor element (3) in the measurement position.

## Revendications

**1.** Capteur (1) pour la mesure de l'intensité d'un champ électrique (13), comprenant :

un élément de base (2),
un élément de capteur (3) avec au moins un conducteur électrique (5), dans lequel l'élément de capteur (3) peut être dévié, par l'action du champ électrique (13) sur le conducteur électrique (5), d'une position de repos vers une position de mesure (3a),

une unité d'analyse (20) pour la mesure de la déviation de l'élément de capteur (3) vers la position de mesure (3a),
un contre-élément (4) avec au moins une partie de couplage électro-conductrice (7), dans lequel la partie de couplage électro-conductrice (7) s'étend sur le contre-élément (4), à l'état de repos de l'élément de capteur (3), près d'une portion de couplage (6) du conducteur électrique (5) sur l'élément de capteur (3), **caractérisé en ce que**
la partie de couplage électro-conductrice (7) est reliée, pour le couplage capacitif avec la portion de couplage (6) du conducteur électrique (5) sur l'élément de capteur (3), avec une source de tension (10a), dans lequel la source de tension (10a) est une source de tension à courant alternatif.

**2.** Capteur (1) selon la revendication 1, **caractérisé en ce que** la partie de couplage (7) sur le contre-élément (4) s'étend parallèlement à la portion de couplage (6) du conducteur électrique (5) sur l'élément de capteur (3).

**3.** Capteur (1) selon la revendication 1 ou 2, **caractérisé en ce que** la partie de couplage (7) sur le contre-élément (4) et la portion de couplage (6) sur l'élément de capteur (3) forment une structure internumérique.

**4.** Capteur (1) selon l'une des revendications 1 à 3, **caractérisé en ce que** le contre-élément (4) est disposé, dans la position de repos de l'élément de capteur (3), dans le même plan que l'élément de capteur (3).

**5.** Capteur (1) selon l'une des revendications 1 à 4, **caractérisé en ce que** le contre-élément (4) est disposé, dans la position de repos de l'élément de capteur (3), parallèlement et à une distance normale par rapport à l'élément de capteur (3).

**6.** Capteur (1) selon l'une des revendications 1 à 5, **caractérisé en ce que** l'élément de capteur (3) est relié, au niveau de deux extrémités opposées, avec l'élément de base (2).

**7.** Capteur (1) selon l'une des revendications 1 à 6, **caractérisé en ce qu'**une extrémité de l'élément de capteur (3) est reliée avec l'élément de base (2), dans lequel l'autre extrémité de l'élément de capteur (3) dépasse librement.

**8.** Capteur (1) selon l'une des revendications 1 à 7, **caractérisé en ce que** l'élément de capteur (3) présente une forme de base en T, en U ou une forme de barre, dans lequel, sur la forme de base en T, en U ou sur la forme de barre, une structure internumérique peut être réalisée.

9.  Capteur (1) selon l'une des revendications 1 à 8, **caractérisé en ce que** le contre-élément (4) est constitué d'une seule pièce avec l'élément de base (2).

10. Capteur (1) selon l'une des revendications 1 à 9, **caractérisé en ce que** le contre-élément (4) est logé de manière mobile sur l'élément de base (2).

11. Capteur (1) selon l'une des revendications 1 à 10, **caractérisé en ce que** l'élément de capteur (3) comprend deux conducteurs électriques (5) et le contre-élément (4) comprend deux parties de couplage électro-conductrices (7), dans lequel les parties de couplage électro-conductrices (7) sur le contre-élément (4) s'étendent près des portions de couplage (6) des conducteurs électriques (5) sur l'élément de capteur (3).

12. Capteur (1) selon l'une des revendications 1 à 11, **caractérisé en ce que** le conducteur électrique (5) sur l'élément de capteur (3) est relié avec une autre source de tension (10b), plus particulièrement une source de tension à courant alternatif.

13. Capteur (1) selon la revendication 12, **caractérisé en ce que** l'élément de capteur (3) comprend deux conducteurs électriques (5), qui sont reliés avec d'autres sources de tension (10b) de signes différents.

14. Capteur (1) selon l'une des revendications 1 à 11, **caractérisé en ce que** la source de tension (10a) est conçue pour appliquer, par induction, une charge dans le conducteur électrique (5) de l'élément de capteur (3).

15. Procédé de mesure de l'intensité d'un champ électrique (13) avec les étapes suivantes :

    disposition d'un capteur (1) selon l'une des revendications 1 à 14,
    déviation de l'élément de capteur (3) par l'action du champ électrique (13) sur le conducteur électrique (5) de la position de repos à la position de mesure et
    mesure de la déviation de l'élément de capteur (3) dans la position de mesure.

Fig. 1a

Fig. 1b

Fig. 1c

Fig. 1d

Fig. 1e

Fig. 1f

Fig. 1g

Fig. 2a

Fig. 2b

Fig. 3a

Fig. 3b

Fig. 4a

Fig. 4b

Fig. 4c

Fig. 5a

Fig. 5b

Fig. 6a

Fig. 6b

Fig. 7a

Fig. 7b

Fig. 8a

Fig. 8b

Fig. 9a

Fig. 9b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2019120795 A1
- US 2019137555 A1
- CN 103675481 B
- CN 108508284 A
- EP 1569023 A1

**In der Beschreibung aufgeführte Nicht-Patentliteratur**

- **LIYANAGE, S.** ; **SHAFAI, C.** ; **CHEN, T.** ; **RAJA-PAKSE, A.** Torsional Moving Electric Field Sensor with Modulated Sensitivity and without Reference Ground. *Proceedings*, 2017, vol. 1, 350